(19) Europäisches Patentamt
European Patent Office
Office européen des brevets

(11) Publication number: 0 304 078 B1

(12) EUROPEAN PATENT SPECIFICATION

(45) Date of publication of patent specification: 03.08.94

(51) Int. Cl.[5]: **H01L 39/24**, H01L 39/08, C23C 14/08

(21) Application number: 88113504.0

(22) Date of filing: 19.08.88

(54) **Composite superconductor layer structure.**

(30) Priority: 21.08.87 JP 208670/87

(43) Date of publication of application:
22.02.89 Bulletin 89/08

(45) Publication of the grant of the patent:
03.08.94 Bulletin 94/31

(84) Designated Contracting States:
DE FR GB

(56) References cited:
EP-A- 0 144 217

ADVANCED CERAMIC MATERIALS- CERAMIC SUPERCONDUCTORS, vol. 2, no 3B, July 1987, pages 430-434, Westerville, OH, US; P.H. KORBIN et al.: "Superconducting Oxide Thin Films by Ion Beam Sputtering"

(73) Proprietor: MATSUSHITA ELECTRIC INDUSTRI-AL CO., LTD.
1006, Oaza Kadoma
Kadoma-shi, Osaka-fu, 571(JP)

(72) Inventor: Kamada, Takeshi
8-3, Soen-1-chome
Ikeda-shi(JP)
Inventor: Hatta, Shinichiro
201-1028, Higashinakaburi-2-chome
Hirakata-shi(JP)
Inventor: Setsune, Kentaro
24-9, Niwashirodai-4-cho
Sakai-shi(JP)

(74) Representative: Patentanwälte Leinweber & Zimmermann
Rosental 7/II Aufg.
D-80331 München (DE)

## Description

This invention relates to the superconductor, and more particularly to a composite superconductor layer structure.

Recently, it was proposed that the materials of Y-Ba-Cu-O System are the superconductors of higher critical temperature [M.K. Wu et al, Physical Review Letters Vol. 58, No. 9, 908-910 (1987)].

More recently, materials of Bi-Sr-Ca-Cu-O system becoming electrically superconducting above 100 K were found, and materials of Tl-Ba-Ca-Cu-O system exhibiting zero electrical resistance at still higher temperature were successively found.

The details of the superconductivity mechanism of these high Tc superconducting oxides are not clear, but there are possibilities that the transition temperature of these materials may become higher than the room temperature. Superior performances to the conventional binary compounds as the electrical superconductor are expected.

These high Tc superconducting oxides, however, can only be made, at the current technology, through the step of sintering. Therefore, these materials are only available in the forms of ceramic powders or ceramicblocks.

For bringing materials of this kind into practical use, it is strongly desired that the materials are shaped in thin films or in wires. At the current technology, tested specimen are poor in reproducibility and reliability. It is generally considered that good superconducting films and/or wires of these materials are very hardly supplied.

## SUMMARY OF THE INVENTION

The present inventors have found that high Tc superconductor thin films of good characteristics materials can be formed by using a thin film technique, such as sputtering, and specially designing the interface structure of the superconductor film, and invented a novel composite superconductor layer structure based on this finding.

In the superconductor structure, an oxide superconductor coating made of an oxide containing a, b and Cu, where the atomic ratio of the elements a, b and Cu satisfies

$$0.5 \leqq \frac{a+b}{Cu} \leqq 2.5 \quad ,$$

is deposited on a substrate coated with a semiconductor film or on a semiconductor substrate, being made of one material selected from the grop consisting of group II-VI compound semiconductors and the complex materials thereof; group III-V compound semiconductors and the complex materials thereof; the group consisting of polycrystalline silicon and the complex materials thereof and the group consisting of amorphous silicon and the complex materials thereof.

Here, $\underline{a}$ represents at least one species selected from the group consisting of Tl, Bi, Pb, Sc, Y and Lanthanide elements (atomic numbers 57-71), and b represents at least one species selected from the group consisting of group IIa elements of the periodic table such as Ba, Sr, Ca, Be, and Mg.

## BRIEF DESCRIPTION OF THE DRAWING

Fig. 1 is a sectional view of a composite superconductor layer structure according to an embodiment of this invention.

Fig. 2 is a topographic view of a surface state of the composite superconductor layer structure of Fig. 1 observed by a scanning electron micrograph (at a magnification ratio of x 10,000).

In the figures, reference numerals represent as follows:

11 --- crystal substrate, 12 --- semiconductor film, and 13 --- oxide superconductor film.

## DESCRIPTION OF THE PREFERRED EMBODIMENTS

Now, the embodiments of the invention will be described in connection with the accompanying drawing.

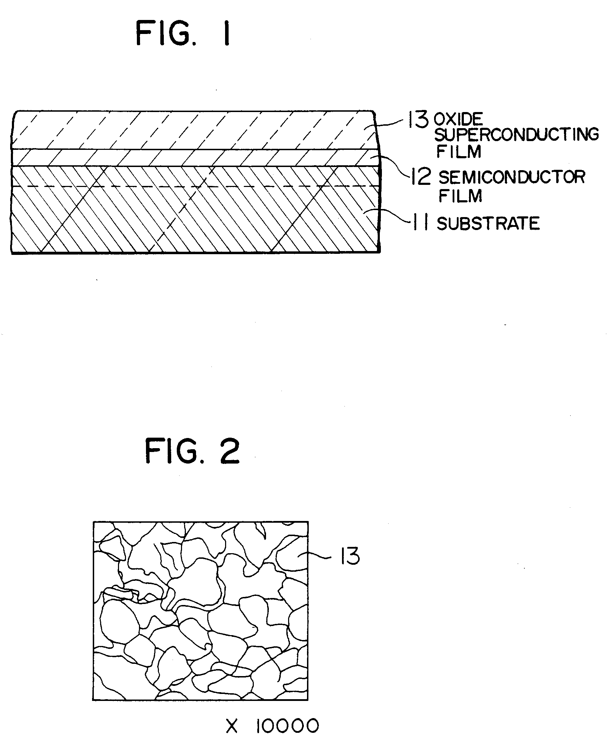

In Fig. 1, an oxide superconductor film 13 is formed, for example by sputtering, on a surface of a semiconductor film coating 12 which is formed on a crystalline substrate 11. The substrate 11 serves to support the oxide film 13. The oxide film 13 is usually formed at a high temperature of not less than 600° C. When a single crystal is used as the substrate 11, the semiconductor film coating 12 formed thereon has its crystallographic axes oriented strongly.

Here, even when trials were made to grow an oxide superconductor film directly on, a single crystal silicon substrate, as disclosed in "Advanced Ceramic Materials", Vol. 2, No. 3 B, July 1987, pp. 430-434, it was hard to grow a film itself due to the difference in thermal expansion coefficient between them. However, when a semiconductor film coating 12 of ZnO or CdS, was formed on the substrate 11, the oxide superconductor film 13 could be grown thereon with a smooth surface and with grain boundaries as shown in Fig. 2. As can be seen from the figure, the film 13 is dense as a whole. The present inventors also found that there could be obtained improvements in film qualities. Further, the present inventors have also confirmed that when silicon is used for the semiconductor film 12, the above-mentioned effects can be obtained for both cases when the film 12 is a polycrystalline silicon and when the film 12 is an amorphous silicon.

Further, the present inventors examined the material of the semiconductor film 12 of Fig. 1, and have confirmed that good results are obtained for group II-VI compound semiconductors and the mixtures thereof, and group III-V compound semiconductors and the mixtures thereof, and that the optimum results are obtained particularly for the case of ZnO. Indeed, similar results were obtained when semiconductor substrates such as of ZnO are used for the substrate 11 itself. From these results, the direct coupling between the semiconductor device and the oxide superconductor device was confirmed.

Further, the present inventors have found that although the substrate 11 is not necessarily a single crystal, there are optimum materials for the substrate 11 of Fig. 1 as seen from its function.

For integrating a semiconductor device of silicon or gallium arsenide with a superconductor structure, it is effective to employ the structure of Fig. 1 where a semiconductor film 12 is provided on a substrate 11. Indeed, the present composite superconductor layer structure can further comprise a film of semiconductor deposited on said oxide superconductor film. The present inventors have examined single crystal materials fitted for use as the substrate 11, and confirmed that single crystals of magnesium oxide, sapphire ($\alpha$-Al$_2$O$_3$), spinels, strontium titanate, silicon, silicon compound, gallium arsenide, are effective. It has also been found that a porcelain body of alumina, magnesium oxide, zirconium oxide, steatite, hostelite, berilia or spinel can be used as the substrate 11.

The superconductor a-b-Cu-O, which is the subject of this invention, is not clearly defined its crystal structure, composition formula, etc., but is also called "oxygen defected perovskite". The present inventors have confirmed that when the molar ratio of elements in the manufactured film lies in the range of

$$0.5 \leq \frac{a + b}{Cu} \leq 2.5 ,$$

the superconducting phenomenon is observed although there may be some differences in the critical temperature.

Further, it has also been confirmed that when the composition $\underline{a}$ is Tl or Bi, the superconducting phenomenon is observed when the composition $\underline{b}$ contains at least two species of group IIa elements of the periodic table and the sum of these elements satisfies the above-mentioned formula.

In sputtering deposition, sintered a-b-Cu-O ceramics are used as the sputtering target. The present inventors have confirmed that at a substrate temperature of 700°C, there is a tendency, when the metallic compositions of the target and of the deposited film are compared, that Cu is apt to be short in the deposited film and that good results can be obtained when the target includes Cu in excess by 50%. Therefore, the present inventors have confirmed that the optimum composition of the target satisfies

$$0.3 \leq \frac{a + b}{Cu} \leq 1.7$$

Here, the target for the sputtering deposition may be in the form of plate-shaped or cylindrical ceramics, and may also be granular or powder shaped sintered bodies. In case of powder bodies, a stainless steele pan, for example, may be used to load the powder.

The present inventors have examined further the effectiveness of these crystalline substrate in detail, and have found that there are optimum orientations in the crystallographic orientation of the crystalline substrate of this kind. Namely, when a silicon device and a superconductor structure are to be integrated, the substrate 11 may be formed, for example, of (100), (110) or (111) oriented plane silicon single crystal, and the film coating 12 may be ZnO which covers the surface of this single crystal.

For further enhancing understanding of this invention, specific embodiments will be explained further.

EMBODIMENTS

A R-plane of sapphire single crystal was used as the substrate 11, and a ZnO film 12 was deposited on the substrate 11 by ac planar magnetron sputtering using a ZnO plate as a target. The pressure of Ar gas was 8 Pa, the sputtering input power was 50W, and the substrate temperature was kept at 400°C. A film of 0.1 $\mu$m thick was evaporated. In this ZnO film, (0001) plane was strongly oriented. On this ZnO film 12, a sternary oxide superconductor film 13 was deposited by rf planar magnetron sputtering using a sintered ErBa$_2$Cu$_{4.5}$O$_8$ body as a target. Here, the pressure of Ar gas was 0.5 Pa, the sputtering input power was 150 W, the sputtering time was 1 hour, the thickness of the deposited film was 0.5 $\mu$m, and the substrate temperature was 700°C. The room temperature resistance of the film was 100Ω and the superconductivity transition temperature was 95 K.

Another embodiment was achieved with (100) plane Si single crystal substrate. On the (100) silicon substrate 11, a GaN film 12 was deposited by ECR (electron 6 cyclotron resonance) sputtering using GaN as a target and a mixture gas of Ar and nitrogen as a sputtering gas and under a pressure of 0.05 Pa. Here, a film of 0.1 $\mu$m thick was grown without heating the substrate. On this film 12, an oxide superconductor film 13 was deposited by rf planar magnetron sputtering using a sintered $GdBa_2Cu_{4.5}O_8$ body as a target. Here, the pressure of the $Ar/O_2$ mixture gas was 0.5 Pa, the sputtering input power was 130W, the sputtering time was 2 hours, the thickness of the film 13 was 0.5 $\mu$m, and the substrate temperature was 600 °C. The deposited film was oriented and had a room temperature resistance of 80 $\Omega$ and a superconductivity transition temperature of 87 K.

Further embodiment was achieved with (100) plane Si single crystal substrate. On the (100) silicon substrate 11, an amorphous silicon film 12 was deposited by ECR plasma CVD using a plasma of a mixture gas formed of $SiH_4$ gas of 10 sccm and $H_2$ gas of 5 sccm. Here, the substrate was not heated and a film 12 of 0.2 $\mu$m thick was formed under a pressure of 0.04 Pa. On this amorphous Si film 12, an oxide superconductor film 13 was deposited by rf planar magnetron sputtering, using a sintered $YBa_2Cu_{4.5}O_8$ body as a target. Here, the substrate temperature was 600 °C, the pressure of $Ar/O_2$ mixture gas was 0.4 Pa, the sputtering input power was 150 W, the the sputtering time was 1 hour, and the thickness of the deposited film was 0.5 $\mu$m. The deposited film was c-axis orientated, and has a room temperature resistance of 150 $\Omega$ and a superconductivity transition temperature of 75 K.

In the oxide superconductor a-b-Cu-O of this kind, details of the composition dependence of the superconducting characteristics on the variation of compositions $\underline{a}$ and $\underline{b}$ are not known. Regarding the composition $\underline{a}$, description has been made on the examples of Er, Gd and Y. The essential nature of the invention does not change when the composition $\underline{a}$ is changed to Tl, Bi, Pb, Sc, La and other Lanthanide elements (atomic numbers 57 to 71), although there may be some changes in the superconductivity transition temperature.

Also regarding the composition $\underline{b}$, the essential nature of the invention does not change when the element $\underline{b}$ is changed in the group IIa elements such as Sr, Ca, Ba, etc., although there may be some changes in the superconductivity transition temperature.

As one of the preferred embodiments of the present invention, it can be pointed out that an oxide superconductor body establishes direct plane contact with a semiconductor body of group II-VI compound semiconductor, group III-V compound semiconductor or amorphous or polycrystalline silicon.

As has been described above, it is made possible to form a totally dense superconductor film and hence to raise the critical current density according to the invention. The variety of substrate usable has increased by the intervention of the semiconductor film. It is made possible to integrate a superconductor structure with a Si or GaAs device according to the invention. Thus, the superconductor structure can form part of various superconductor devices such as a superconductor transistor. Further, superconductor ribbons can also be made using single crystal ribbons such as silicon ribbons. The transition temperature of the oxide superconductor may become the room temperature. The range of practical use in very wide through integration with various elements. The industrial value of the invention is thus high.

**Claims**

1. A composite superconductor layer structure comprising:

    a substrate (11) including at least a surface layer (12) of semiconductor;

    an oxide superconductor film (13) formed on said substrate and made of an oxide material containing composition $\underline{a}$, composition $\underline{b}$, and Cu where composition $\underline{a}$ is at least one species selected from the group consisting of Bi, Tl, Pb, Sc, Y and Lanthanide elements (atomic numbers 57 to 71), and composition $\underline{b}$ is at least one species of group IIa elements, and the molar ratio of the compositions a, b and Cu satisfy

$$0.5 \leq \frac{a + b}{Cu} \leq 2.5 \; ;$$

    wherein said surface layer (12) is made of one material selected from the group consisting of group II-IV compound semiconductors and the complex materials thereof; group III-V compound semiconductors and the complex materials thereof; the group consisting of polycrystalline silicon and the complex materials thereof and the group consisting of amorphous silicon and the complex materials thereof.

2. A composite superconductor layer structure according to claim 1, further comprising a film of semiconductor deposited on said oxide superconductor film.

3. A composite superconductor layer structure according to claim 2, further comprising another oxide superconductor film deposited on said film of semiconductor.

4. A composite superconductor layer structure according to claim 1, wherein said substrate (11) includes a single crystal body and said surface layer (12) of semiconductor is formed of an epitaxial layer on said single crystal body, and said oxide superconductor film (13) has strong orientation on the epitaxial layer.

5. A composite superconductor layer structure according to claim 1, wherein said substrate includes a single crystal body (11) of at least one species selected from the group consisting of magnesium oxide (MgO), sapphire ($\alpha$-$Al_2O_3$), spinel, strontium titanate ($SrTiO_3$), silicon, silicon compounds, gallium arsenide (GaAs), zirconium oxide ($ZrO_2$).

6. A composite superconductor layer structure according to claim 1, wherein said substrate (11) includes a porcelain body of at least one species selected from the group consisting of alumina, magnesium oxide (MgO), zirconium oxide ($ZrO_2$), steatite, holstelite ($2MgO$-$SiO_2$), berilia (BeO) and spinel.

7. A composite superconductor layer structure according to claim 4, wherein said single crystal body (11) is a magnesium oxide single crystal body which has one of (100) planes and (110) planes.

8. A composite superconductor layer structure according to claim 4, wherein said single crystal body (11) is a sapphire single crystal body which has one of R-planes, C-planes and a-planes.

9. A composite superconductor layer structure according to claim 4, wherein said single crystal body (11) is a silicon single crystal body which has one of (100) planes, (110) planes and (111) planes.

10. A composite superconductor layer structure according to claim 4, wherein said single crystal body (11) is a spinel single crystal body which has a (111) plane.

11. A composite superconductor layer structure according to claim 4, wherein said single crystal body (11) is a spinel single crystal body which has a (110) plane.

12. A composite superconductor layer structure according to claim 4, wherein said single crystal body (11) is a spinel single crystal body which has a (100) plane.

13. A composite superconductor layer structure according to claim 4, wherein said single crystal body (11) is a strontium titanate single crystal body which has one of (100) planes and (110) planes.

**Patentansprüche**

1. Verbundschicht-Supraleiterstruktur mit:
einem zumindest eine Oberflächenschicht (12) aus einem Halbleiter enthaltenden Substrat (11),
einem auf dem Substrat gebildeten Oxidsupraleiterfilm (13), der aus einem eine Zusammensetzung a, eine Zusammensetzung b und Cu enthaltenden Oxidmaterial hergestellt ist, wobei die Zusammensetzung a zumindest eine aus der aus Bi, Tl Pb, Sc, Y und Lanthanidenelementen (Ordnungszahlen 57 bis 71) bestehenden Gruppe ausgewählte Spezies ist und die Zusammensetzung b zumindest eine Spezies der Elemente aus der Gruppe IIa ist und das Molverhältnis der Zusammensetzung a, b und Cu der Gleichung

$$0,5 \leq \frac{a + b}{Cu} \leq 2,5$$

genügt, wobei die Oberflächenschicht (12) aus einem Material hergestellt ist ausgewählt aus der Gruppe bestehend aus II-IV-Gruppen-Verbindungshalbleitern und den komplexen Materialien davon; III-V-Gruppen-Verbindungshalbleitern und den komplexen Materialien davon; der aus polykristallinem Silizium und den komplexen Materialien davon bestehenden Gruppe und der aus amorphem Silizium und den komplexen Materialien davon bestehenden Gruppe.

2. Verbundschicht-Supraleiterstruktur nach Anspruch 1, ferner umfassend einen auf dem Oxidsupraleiterfilm abgeschiedenen Halbleiterfilm.

3. Verbundschicht-Supraleiterstruktur nach Anspruch 2, ferner umfassend einen anderen auf dem Halbleiterfilm abgeschiedenen Oxidsupraleiterfilm.

4. Verbundschicht-Supraleiterstruktur nach Anspruch 1, bei der das Substrat (11) einen Ein-

kristallkörper enthält und die Oberflächen-schicht (12) aus einem Halbleiter aus einer epitaktischen Schicht auf dem Einkristallkörper gebildet ist und der Oxidsupraleiterfilm (13) eine starke Orientierung auf der epitaktischen Schicht aufweist.

5. Verbundschicht-Supraleiterstruktur nach Anspruch 1, bei der das Substrat einen Einkristallkörper (11) aus zumindest einer Spezies ausgewählt aus der aus Magnesiumoxid (MgO), Saphir ($\alpha$-Al$_2$O$_3$), Spinell, Strontiumtitanat (SrTiO$_3$), Silizium, Siliziumverbindungen, Galliumarsenid (GaAs), Zirkoniumoxid (ZrO$_2$) bestehenden Gruppe enthält.

6. Verbundschicht-Supraleiterstruktur nach Anspruch 1, bei der das Substrat (11) einen Porzellankörper aus zumindest einer Spezies ausgewählt aus der aus Aluminiumoxid, Magnesiumoxid (MgO), Zirkonoxid (ZrO$_2$), Steatit, Holstelit (2MgO-SiO$_2$), Berylliumoxid (BeO) und Spinell bestehenden Gruppe enthält.

7. Verbundschicht-Supraleiterstruktur nach Anspruch 4, bei der der Einkristallkörper (11) ein (100)-Ebenen oder (110)-Ebenen aufweisender Magnesiumoxideinkristallkörper ist.

8. Verbundschicht-Supraleiterstruktur nach Anspruch 4, bei der der Einkristallkörper (11) ein R-Ebenen, C-Ebenen oder a-Ebenen aufweisender Saphireinkristallkörper ist.

9. Verbundschicht-Supraleiterstruktur nach Anspruch 4, bei der der Einkristallkörper (11) ein (100)-Ebenen, (110)-Ebenen oder (111)-Ebenen aufweisender Siliziumeinkristallkörper ist.

10. Verbundschicht-Supraleiterstruktur nach Anspruch 4, bei der der Einkristallkörper (11) ein eine (111)-Ebenen aufweisender Spinelleinkristallkörper ist.

11. Verbundschicht-Supraleiterstruktur nach Anspruch 4, bei der der Einkristallkörper (11) ein eine (110)-Ebene aufweisender Spinelleinkristallkörper ist.

12. Verbundschicht-Supraleiterstruktur nach Anspruch 4, bei der der Einkristallkörper (11) ein eine (100)-Ebene aufweisender Spinelleinkristallkörper ist.

13. Verbundschicht-Supraleiterstruktur nach Anspruch 4, bei der der Einkristallkörper (11) ein (100)-Ebenen oder (110)-Ebenen aufweisender Strontiumtitanateinkristallkörper ist.

**Revendications**

1. Structure en couche composite supraconductrice comprenant:
   - un substrat (11) incluant au moins une couche superficielle (12) de semi-conducteur;
   - un film d'oxyde supraconducteur (13) formé sur ledit substrat et fait d'un matériau oxyde contenant une composition $\underline{a}$, une composition $\underline{b}$, et Cu où la composition $\underline{a}$ est au moins une espèce choisie dans le groupe constitué de Bi, Tl, Pb, Sc, Y et des éléments lanthanides (numéros atomiques 57 à 71), et la composition $\underline{b}$ est au moins une espèce des éléments du groupe IIa, et le rapport molaire des compositions a, b et Cu satisfait la relation

$$0,5 \leq \frac{a + b}{Cu} \leq 2,5;$$

dans laquelle ladite couche superficielle (12) est faite d'une matière choisie dans le groupe formé par les semi-conducteurs de composés des groupes II à IV et leurs matières complexes; les semi-conducteurs de composés des groupes III à V et leurs matières complexes; le groupe formé du silicium polycristallin et ses matières complexes et le groupe formé du silicium amorphe et ses matières complexes.

2. Structure en couche composite supraconductrice selon la revendication 1, comprenant de plus un film de semi-conducteur déposé sur ledit film d'oxyde supraconducteur.

3. Structure en couche composite supraconductrice selon la revendication 2, comprenant de plus un autre film d'oxyde supraconducteur déposé sur ledit film de semiconducteur.

4. Structure en couche composite supraconductrice selon la revendication 1, dans laquelle ledit substrat (11) inclut un corps monocristallin et ladite couche superficielle (12) de semi-conducteur est formée d'une couche épitaxiale sur ledit corps monocristallin, et ledit film d'oxyde supraconducteur (13) a une forte orientation sur la couche épitaxiale.

5. Structure en couche composite supraconductrice selon la revendication 1, dans laquelle ledit substrat inclut un corps monocristallin (11) d'au moins une espèce choisie dans le groupe formé par l'oxyde de magnésium (MgO), le saphir ($\alpha$-$Al_2O_3$), le spinelle, le titanate de strontium ($SrTiO_3$), le silicium, les composés du silicium, l'arséniure de gallium (GaAs), l'oxyde de zirconium ($ZrO_2$).

6. Structure en couche composite supraconductrice selon la revendication 1, dans laquelle ledit substrat (11) inclut un corps de porcelaine d'au moins une espèce choisie dans le groupe formé par l'alumine, l'oxyde de magnésium (MgO), l'oxyde de zirconium ($ZrO_2$), la stéatite, l'holstélite ($2MgO$-$SiO_2$), l'oxyde de béryllium (BeO) et le spinelle.

7. Structure en couche composite supraconductrice selon la revendication 4, dans laquelle ledit corps monocristallin (11) est un corps monocristallin d'oxyde de magnésium qui a l'un des plans (100) et des plans (110).

8. Structure en couche composite supraconductrice selon la revendication 4, dans laquelle ledit corps monocristallin (11) est un corps monocristallin de saphir qui a l'un des plans R, des plans C et des plans a.

9. Structure en couche composite supraconductrice selon la revendication 4, dans laquelle ledit corps monocristallin (11) est un corps monocristallin de silicium qui a l'un des plans (100), des plans (110) et des plans (111).

10. Structure en couche composite supraconductrice selon la revendication 4, dans laquelle ledit corps monocristallin (11) est un corps monocristallin de spinelle qui a un plan (111).

11. Structure en couche composite supraconductrice selon la revendication 4, dans laquelle ledit corps monocristallin (11) est un corps monocristallin de spinelle qui a un plan (110).

12. Structure en couche composite supraconductrice selon la revendication 4, dans laquelle ledit corps monocristallin (11) est un corps monocristallin de spinelle qui a un plan (100).

13. Structure en couche composite supraconductrice selon la revendication 4, dans laquelle ledit corps monocristallin (11) est un corps monocristallin de titanate de strontium qui a l'un des plans (100) et des plans (110).

# FIG. 1

13 OXIDE
SUPERCONDUCTING
FILM

12 SEMICONDUCTOR
FILM

11 SUBSTRATE

# FIG. 2

13

X 10000